(19) Europäisches Patentamt
European Patent Office
Office européen des brevets

(11) **EP 4 726 420 A1**

(12) **EUROPEAN PATENT APPLICATION**
published in accordance with Art. 153(4) EPC

(43) Date of publication:
**15.04.2026  Bulletin 2026/16**

(21) Application number: **24840065.7**

(22) Date of filing: **09.07.2024**

(51) International Patent Classification (IPC):
*G01R 31/396* (2019.01)    *G01R 31/385* (2019.01)
*G01R 19/00* (2006.01)     *G01R 19/165* (2006.01)
*G01R 31/392* (2019.01)    *G01R 31/367* (2019.01)

(52) Cooperative Patent Classification (CPC):
Y02E 60/10

(86) International application number:
**PCT/KR2024/009774**

(87) International publication number:
**WO 2025/014255 (16.01.2025 Gazette 2025/03)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority:  **12.07.2023   KR 20230090673**

(71) Applicant: **LG Energy Solution, Ltd.
Seoul 07335 (KR)**

(72) Inventor: **JANG, Tae Hyeok
Daejeon 34122 (KR)**

(74) Representative: **Goddar, Heinz J.
Boehmert & Boehmert
Anwaltspartnerschaft mbB
Pettenkoferstrasse 22
80336 München (DE)**

(54) **BATTERY MANAGEMENT APPARATUS AND OPERATING METHOD THEREOF**

(57)    A battery management apparatus according to an embodiment disclosed herein includes a voltage measurement unit configured to measure a voltage of each of a plurality of batteries and a controller configured to calculate, as a first voltage of each of the plurality of batteries, a deviation between an average voltage of the plurality of batteries and the voltage of each of the plurality of batteries, calculate a long moving average and a short moving average of the first voltage for each of the plurality of batteries, determine at least one noise battery based on the short moving average of each of the plurality of batteries, calculate a first deviation that is a deviation between the long moving average and the short moving average for each of a plurality of target batteries except for the at least one noise battery among the plurality of batteries, and calculate a second deviation that is a mean value of first deviations of the plurality of target batteries and diagnose at least one target battery among the plurality of target batteries based on a first diagnosis deviation that is a difference between the first deviation and the second deviation for each of the plurality of target batteries.

<u>200</u>

| VOLTAGE MEASUREMENT UNIT <u>210</u> | CONTROLLER <u>220</u> |

FIG.2

EP 4 726 420 A1

**Description**

**TECHNICAL FIELD**

CROSS-REFERENCE TO RELATED APPLICATION

This application claims priority to and the benefit of Korean Patent Application No. 10-2023-0090673 filed in the Korean Intellectual Property Office on July 12, 2023, the entire content of which is incorporated herein by reference.

TECHNICAL FIELD

Embodiments disclosed herein relate to a battery management apparatus and an operating method thereof.

**BACKGROUND ART**

An electric vehicle is supplied with electricity from outside to charge a battery cell, and then a motor is driven by a voltage charged in the battery cell to obtain power. A battery cell undergoes internal deformation and degeneration through various charging and discharging during production and use, with physical/chemical characteristics thereof changing, resulting in venting due to internal short-circuit, external short-circuit, and lithium precipitation or in an under-voltage defect in which a voltage of a battery cell decreases below a certain level.

When a defect occurs inside the battery cell, direct problems may occur in the battery cell, such as deterioration of battery cell performance, the increased possibility of ignition due to leakage of an electrolyte, etc. Thus, a technique for determining whether the battery cell is abnormal is required.

A conventional battery management apparatus may diagnose voltage abnormality of a battery cell by using a voltage deviation of an individual battery cell with respect to an average voltage of battery cells, but this method may not adjust a threshold that is a criterion for diagnosing an abnormal battery cell below a certain level due to its vulnerability to noise, and may not detect an abnormal voltage of a battery cell due to micro-disconnection occurring in an electric vehicle.

**DISCLOSURE**

**TECHNICAL PROBLEM**

Embodiments disclosed herein aim to provide a battery management apparatus and an operating method thereof in which noise of a deviation between a long moving average and a short moving average of a voltage of a battery may be removed to accurately diagnose an abnormal battery cell.

Technical problems of the embodiments disclosed herein are not limited to the above-described technical problems, and other unmentioned technical problems would be clearly understood by one of ordinary skill in the art from the following description.

**TECHNICAL SOLUTION**

A battery management apparatus according to an embodiment disclosed herein includes a voltage measurement unit configured to measure a voltage of each of a plurality of batteries and a controller configured to calculate, as a first voltage of each of the plurality of batteries, a deviation between an average voltage of the plurality of batteries and the voltage of each of the plurality of batteries, calculate a long moving average and a short moving average of the first voltage for each of the plurality of batteries, determine at least one noise battery based on the short moving average of each of the plurality of batteries, calculate a first deviation that is a deviation between the long moving average and the short moving average for each of a plurality of target batteries except for the at least one noise battery among the plurality of batteries, and calculate a second deviation that is a mean value of first deviations of the plurality of target batteries and diagnose at least one target battery among the plurality of target batteries based on a first diagnosis deviation that is a difference between the first deviation and the second deviation for each of the plurality of target batteries.

According to an embodiment, the controller may be further configured to calculate a mean value, a median value, or a minimum value of voltages of the plurality of batteries as the average voltage of the plurality of batteries and calculate a mean value, a median value, or a minimum value of the first deviations of the plurality of target batteries as the second deviation.

According to an embodiment, the controller may be further configured to calculate a mean value, a median value, or a minimum value of short moving averages of the plurality of batteries as an average short moving average of the plurality of batteries and calculate a deviation between the average short moving average of the plurality of batteries and the short moving average of each of the plurality of batteries as a second voltage of each of the plurality of batteries.

According to an embodiment, the controller may be further configured to calculate a long moving average of the second voltage of each of the plurality of batteries as ripple noise of each of the plurality of batteries.

According to an embodiment, the controller may be further configured to set a first threshold value by multiplying an average of the ripple noise of the plurality of batteries by a first threshold constant and determine a battery having the ripple noise not equal to the first threshold value among the plurality of batteries as the at least one noise battery.

According to an embodiment, the controller may be further configured to perform normalization by dividing the first diagnosis deviation of each of the plurality of target batteries by a maximum value between a value, obtained by multiplying the second deviation by a second threshold constant, and a third threshold constant to calculate a second diagnosis deviation of each of the plurality of target batteries.

According to an embodiment, the controller may be further configured to diagnose at least one target battery among the plurality of target batteries based on whether the second diagnosis deviation of each of the plurality of target batteries exceeds the second threshold value.

An operating method of a battery management apparatus according to an embodiment disclosed herein includes measuring a voltage of each of a plurality of batteries, calculating, as a first voltage of each of the plurality of batteries, a deviation between an average voltage of the plurality of batteries and the voltage of each of the plurality of batteries, calculating a long moving average and a short moving average of the first voltage for each of the plurality of batteries, determining at least one noise battery based on the short moving average of each of the plurality of batteries, calculating a first deviation that is a deviation between the long moving average and the short moving average for each of a plurality of target batteries except for the at least one noise battery among the plurality of batteries, calculating a second deviation that is a mean value of the first deviations of the plurality of target batteries, and diagnosing at least one target battery among the plurality of target batteries based on a first diagnosis deviation that is a difference between the first deviation and the second deviation for each of the plurality of target batteries.

According to an embodiment, the calculating, as the first voltage of each of the plurality of batteries, of the deviation between the average voltage of the plurality of batteries and the voltage of each of the plurality of batteries may include calculating a mean value, a median value, or a minimum value of voltages of the plurality of batteries as the average voltage of the plurality of batteries, and the calculating of the second deviation that is a mean value of the first deviations of the plurality of target batteries may include calculating a mean value, a median value, or a minimum value of the first deviations of the plurality of target batteries as the second deviation.

According to an embodiment, the determining of the at least one noise battery based on the short moving average of each of the plurality of batteries may include calculating a mean value, a median value, or a minimum value of short moving averages of the plurality of batteries as an average short moving average of the plurality of batteries and calculating a deviation between the average short moving average of the plurality of batteries and the short moving average of each of the plurality of batteries as a second voltage of each of the plurality of batteries.

According to an embodiment, the determining of the at least one noise battery based on the short moving average of each of the plurality of batteries may include calculating a long moving average of the second voltage of each of the plurality of batteries as ripple noise of each of the plurality of batteries.

According to an embodiment, the determining of the at least one noise battery based on the short moving average of each of the plurality of batteries may include setting a first threshold value by multiplying an average of the ripple noise of the plurality of batteries by a first threshold constant and determining a battery having the ripple noise not equal to the first threshold value among the plurality of batteries as the at least one noise battery.

According to an embodiment, the diagnosing of the at least one target battery among the plurality of target batteries based on the first diagnosis deviation that is the difference between the first deviation and the second deviation for each of the plurality of target batteries may include performing normalization by dividing the first diagnosis deviation of each of the plurality of target batteries by a maximum value between a value, obtained by multiplying the second deviation by a second threshold constant, and a third threshold constant to calculate a second diagnosis deviation of each of the plurality of target batteries.

According to an embodiment, the diagnosing of the at least one target battery among the plurality of target batteries based on the first diagnosis deviation that is the difference between the first deviation and the second deviation for each of the plurality of target batteries may include diagnosing at least one target battery among the plurality of target batteries based on whether the second diagnosis deviation of each of the plurality of target batteries exceeds the second threshold value.

ADVANTAGEOUS EFFECTS

The battery management apparatus and the operating method thereof according to an embodiment disclosed herein may accurately diagnose an abnormal battery cell by removing noise of a deviation between a long moving average and a short moving average of a voltage of a battery.

## DESCRIPTION OF DRAWINGS

FIG. 1 illustrates a battery pack according to an embodiment disclosed herein.

FIG. 2 is a block diagram illustrating a configuration of a battery management apparatus, according to an embodiment disclosed herein.

FIG. 3 is a graph showing a voltage of a battery cell according to an embodiment disclosed herein.

FIG. 4 is a flowchart illustrating a method of identifying a target battery cell of a controller, according to an embodiment disclosed herein.

FIG. 5 is a graph showing a long moving average and a short moving average of a first voltage of a battery cell, according to an embodiment disclosed herein.

FIG. 6 is a graph showing ripple noise of a battery cell according to an embodiment disclosed herein.

FIG. 7 is a flowchart illustrating a method of diagnosing a target battery cell by a controller, according to an embodiment disclosed herein.

FIG. 8 is a graph showing a second diagnosis deviation of a battery cell according to an embodiment disclosed herein.

FIG. 9 is a flowchart of an operating method of a battery management apparatus according to an embodiment disclosed herein.

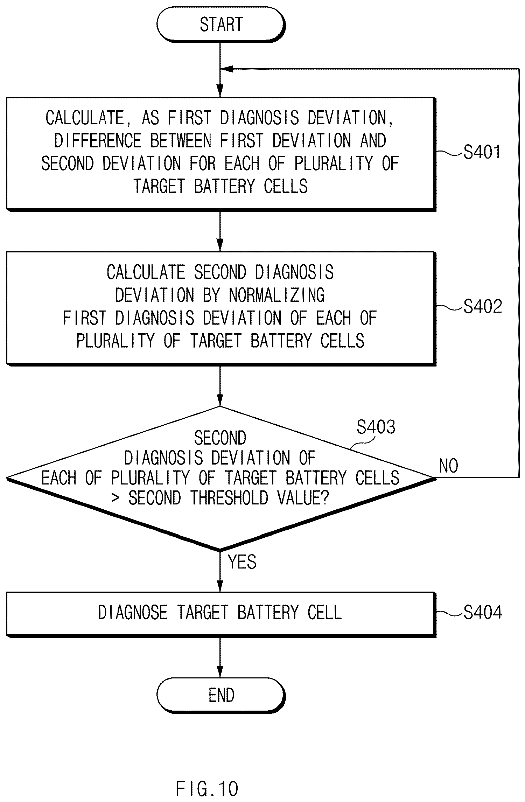

FIG. 10 is a flowchart illustrating an operating method of diagnosing a target battery cell by a battery management apparatus, according to an embodiment disclosed herein.

FIG. 11 is a block diagram showing a hardware configuration of a computing system for performing an operating method of a battery management apparatus, according to an embodiment disclosed herein.

## MODE FOR INVENTION

Hereinafter, some embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present document.

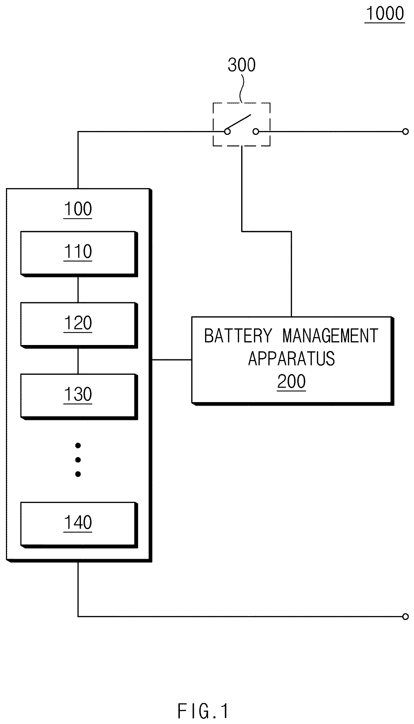

FIG. 1 illustrates a battery pack according to an embodiment disclosed herein.

Referring to FIG. 1, a battery pack 1000 according to an embodiment disclosed herein may include a battery module 100, a battery management apparatus 200, and a relay 300. According to various embodiments, the battery module 100 may be a battery cell, and in this case, the battery pack 1000 may have a cell-to-pack structure.

Meanwhile, although one battery module 100 is illustrated in FIG. 1, the battery module 100 may be configured in plural and the battery pack 1000 may have a stacked structure of a plurality of battery modules, according to an embodiment. The battery module 100 may include a plurality of battery cells 110, 120, 130, and 140. Although the plurality of battery cells are illustrated as four in FIG. 1, the present disclosure is not limited thereto, and the battery module 100 may include n battery cells (n is a natural number equal to or greater than 2). Each of the plurality of battery cells 110, 120, 130, and 140 may be a cell group or a battery bank in which at least two battery cells are connected in parallel.

The battery module 100 may supply power to a target device (not shown). To this end, the battery module 100 may be electrically connected to the target device. Herein, the target device may include an electrical, electronic, or mechanical device that operates by receiving power from the battery pack 1000 including the plurality of battery cells 110, 120, 130, and 140, and the target device may be, for example, an electric vehicle (EV) or an energy storage system (ESS), but is not limited thereto.

The plurality of battery cells 110, 120, 130, and 140, each of which is a basic unit of a battery available by charging and discharging electrical energy, may be a lithium ion (Li-ion) battery, an Li-ion polymer battery, a nickel-cadmium (Ni-Cd) battery, a nickel hydrogen (Ni-MH) battery, etc., and are not limited thereto.

The battery management apparatus (a battery management system (BMS)) 200 may manage and/or control a state and/or an operation of the battery module 100. For example, the battery management apparatus 200 may manage and/or control the states and/or operations of the plurality of battery cells 110, 120, 130, and 140 included in the battery module 100. The battery management apparatus 200 may manage charging and/or discharging of the battery module 100.

The battery management apparatus 200 may control an operation of the relay 300. For example, the battery management apparatus 200 may short-circuit the relay 300 to supply power to the target device. The battery management apparatus 200 may short-circuit the relay 300 when a charging device is connected to the battery pack 1000.

In addition, the battery management apparatus 200 may monitor a voltage, a current, a temperature, etc., of the battery module 100 and/or each of the plurality of battery cells 110, 120, 130, and 140 included in the battery module 100. A sensor or various measurement modules for monitoring performed by the battery management apparatus 200, which are not shown, may be additionally installed in the battery module 100, a charging/discharging path, any position of the battery module 100, etc. The battery management apparatus 200 may calculate a parameter indicating a state of the battery module 100, e.g., a state of charge (SOC), a state of health (SOH) etc., based on a measurement value such as monitored voltage, current, temperature, etc.

For the plurality of battery cells 110, 120, 130, and 140, as a period of use or the number of times of use increases, a capacity may decrease, internal resistance may increase, and various factors of the battery may change. The battery management apparatus 200 may diagnose an abnormal phenomenon inside the plurality of battery cells 110, 120, 130, and 140 based on data of various factors changing with deterioration of the battery cells.

When a defect occurs in a battery cell due to various causes such as a detect in a production stage, internal deformation and degeneration through a plurality of charging and discharging, an external impact, etc., a voltage change may occur more quickly and significantly in comparison to a normal battery cell. By using a phenomenon in which a voltage change is faster and more significant in a battery cell having an internal defect occurring than in a normal battery cell in an idle period, the battery management apparatus 200 may compare voltage data of the idle period of each of the plurality of battery cells 110, 120, 130, and 140 with statistic normal voltage data of an idle period of a normal battery cell to diagnose an abnormal battery cell among the plurality of battery cells 110, 120, 130, and 140.

Specifically, in the abnormal battery cell, a voltage drops in an idle period after charging when compared to a normal battery cell, and a greater deviation in voltage behavior occurs than a voltage behavior of the normal battery cell, such that the voltage behavior is biased to one side, resulting in a great skewness. The battery management apparatus 200 may determine whether there is an abnormal battery cell among the plurality of battery cells 110, 120, 130, and 140 by using a greater deviation and a greater skewness of the voltage behavior of the abnormal battery cell than those of the voltage behavior of the normal battery cell.

The battery management apparatus 200 may calculate an average of voltages of the plurality of battery cells 110, 120, 130, and 140 and a deviation dV of the voltage of each of the plurality of battery cells 110, 120, 130, and 140. The battery management apparatus 200 may determine an abnormal behavior of a voltage of at least one battery cell among the plurality of battery cells 110, 120, 130, and 140 by using the deviation of the voltage of each of the plurality of battery cells 110, 120, 130, and 140, thereby diagnosing a corresponding battery cell.

The battery management apparatus 200 may determine a plurality of target battery cells by excluding a noise battery cell suspected to be noise data among a voltage deviation of each of the plurality of battery cells 110, 120, 130, and 140. After determining the plurality of target battery cells, the battery management apparatus 200 may diagnose a target battery cell by using voltage deviation data of each of the plurality of target battery cells included in the battery pack 1000. The battery management apparatus 200 may diagnose an abnormal battery cell suspected to be an abnormal voltage by using the amplified voltage deviation data.

The following operation of the battery management apparatus 200 may also be performed in the battery management apparatus 200 or various devices such as a server, a cloud, a charger, a charger/discharger, etc., connected to a vehicle having the battery management apparatus 200 mounted thereon.

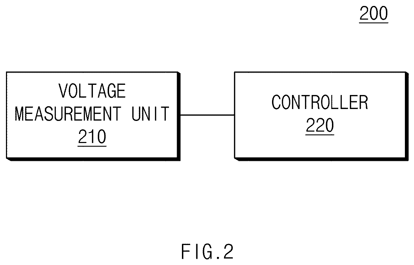

FIG. 2 is a block diagram illustrating a configuration of a battery management apparatus, according to an embodiment disclosed herein.

Hereinbelow, a configuration of the battery management apparatus 200 will be described in detail with reference to FIG. 2.

Referring to FIG. 2, the battery management apparatus 200 may include a voltage measurement unit 210 and a controller 220.

The voltage measurement unit 210 may calculate the voltage of each of the plurality of battery cells 110, 120, 130, and 140. The voltage measurement unit 210 may calculate the voltage of each of the plurality of battery cells 110, 120, 130, and 140 for each unit time to calculate time-series data of the voltage of each of the plurality of battery cells 110, 120, 130, and 140. According to an embodiment, the voltage measurement unit 210 may continuously calculate voltage rise and drop and long-term relaxation data of the plurality of battery cells 110, 120, 130, and 140 in charging, an idle period after charging, discharging, and an idle period after discharging.

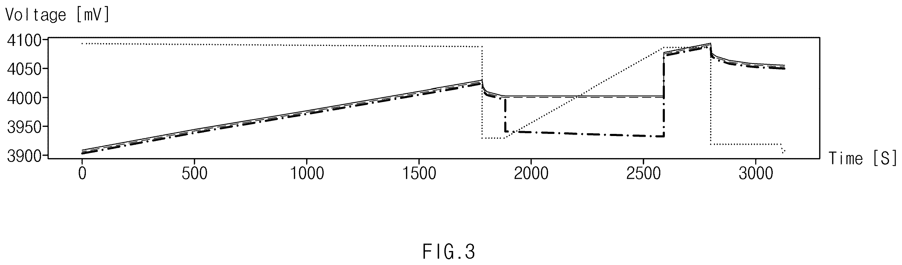

FIG. 3 is a graph showing a voltage of a battery cell according to an embodiment disclosed herein.

Referring to FIG. 3, the voltage measurement unit 210 may calculate the time-series data of the voltage of each of the plurality of battery cells 110, 120, 130, and 140 by measuring the voltages of the plurality of battery cells 110, 120, 130, and 140 in charging, an idle period after charging, discharging, and an idle period after discharging. The voltage measurement unit 210 may generate a graph indicating a voltage change of each of the plurality of battery cells 110, 120, 130, and 140 by measuring the voltage of each of the plurality of battery cells 110, 120, 130, and 140 for each unit time.

The controller 220 may calculate an average voltage V_avg of the plurality of battery cells 110, 120, 130, and 140. According to an embodiment, the controller 220 may calculate a mean value Mean, a median value Median, or a minimum value Min of the voltages of the plurality of battery cells 110, 120, 130, and 140 as the average voltage V_avg of the plurality of battery cells 110, 120, 130, and 140. The controller 220 may calculate a deviation dV between the average voltage V_avg and the voltage of each of the plurality of battery cells 110, 120, 130, and 140.

According to an embodiment, the controller 220 may calculate, as a first voltage dV1, the deviation dV between the average voltage V_avg and the voltage of each of the plurality of battery cells 110, 120, 130, and 140. According to an embodiment, the controller 220 may calculate the voltage of each of the plurality of battery cells 110, 120, 130, and 140 as the first voltage dV1 of each of the plurality of battery cells 110, 120, 130, and 140. Hereinbelow, a description will be made using the deviation dV between the voltage of each of the plurality of battery cells 110, 120, 130, and 140 and the average voltage V_avg as the first voltage of each of the plurality of battery cells 110, 120, 130, and 140, but the present disclosure is not limited thereto.

The controller 220 may determine at least one noise battery cell among the plurality of battery cells 110, 120, 130, and 140, based on the first voltage dV1 of each of the plurality of battery cells 110, 120, 130, and 140. After determining the at least one noise battery cell based on the first voltage dV1 of each of the plurality of battery cells 110, 120, 130, and 140, the controller 220 may identify a plurality of target battery cells except for the at least one noise battery cell from among the plurality of battery cells 110, 120, 130, and 140.

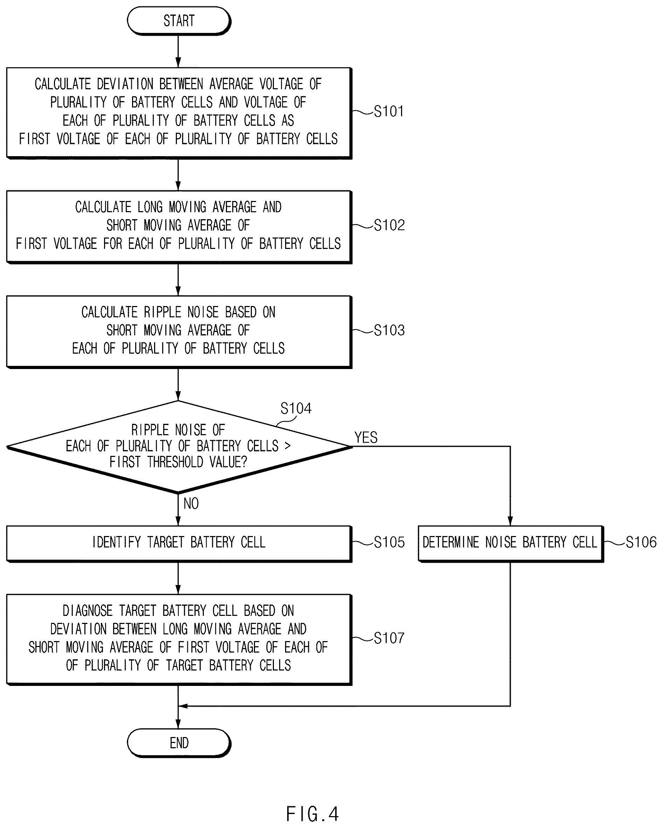

FIG. 4 is a flowchart illustrating a method of identifying a target battery cell of a controller, according to an embodiment disclosed herein.

Hereinbelow, a method, performed by the controller 220, of identifying a target battery cell will be described in detail with reference to FIG. 4.

Referring to FIG. 4, in operation S101, the controller 220 may calculate, as the first voltage dV1, the deviation dV between the average voltage V_avg and the voltage of each of the plurality of battery cells 110, 120, 130, and 140.

In operation S102, the controller 220 may calculate a moving average of the first voltage dV1 of each of the plurality of battery cells 110, 120, 130, and 140. Herein, the moving average may be an average of some data extracted during movement on a window of a certain size among the entire data. Herein, the window may be a reference period for determining some of the entire data extracted for use. A start point of the window may be a point preceding the present point by a reference time, an end point of the window may be the present point. For example, when the window corresponds to one week, the controller 220 may extract data obtained during the recent one week from the present point from among the entire data.

In operation S102, the controller 220 may calculate the moving average of the first voltage dV1 of each of the plurality of battery cells 110, 120, 130, and 140 by using the first voltage dV1 extracted during movement in a window from time-series data of the entire first voltage dV1 of each of the plurality of battery cells 110, 120, 130, and 140. In operation S102, the controller 220 may calculate a continuous moving average of the first voltage dV1 of each of the plurality of battery cells 110, 120, 130, and 140 by using the first voltage dV1 continuously extracted during movement in the window from the entire first voltage dV1 of each of the plurality of battery cells 110, 120, 130, and 140.

In operation S102, the controller 220 may calculate the time-series data of a long moving average dV1_LMA and a short moving average dV1_SMA of each of the plurality of battery cells 110, 120, 130, and 140 by measuring the voltages of the plurality of battery cells 110, 120, 130, and 140 in charging, an idle period after charging, discharging, and an idle period after discharging. For example, the controller 220 may calculate a voltage deviation dV with respect to the average voltage V_avg or the moving average of the voltage of each of the plurality of battery cells 110, 120, 130, and 140, by applying any one of a simple moving average, a weighted moving average, or an exponential moving average (EMA) to the entire first voltage dV1 data of each of the plurality of battery cells 110, 120, 130, and 140.

In operation S102, according to an embodiment, the controller 220 may calculate the EMA of the first voltage dV1 of each of the plurality of battery cells 110, 120, 130, and 140 by applying the EMA to the entire first voltage dV1 data of each of the plurality of battery cells 110, 120, 130, and 140. The EMA refers to a sort of weighted moving averaging in which a higher weight value is applied to the recent data, while using data of all the past periods.

In operation S102, the controller 220 may calculate a plurality of moving averages having different window sizes by using the entire first voltage dV1 data of each of the plurality of battery cells 110, 120, 130, and 140. According to an embodiment, the controller 220 may calculate a long moving average having a relatively long window length and a short moving average having a relatively short window length by using the entire first voltage dV1 data of each of the plurality of battery cells 110, 120, 130, and 140. For example, the window size of the long moving average may include 100 seconds, and the window size of the short moving average may include 10 seconds.

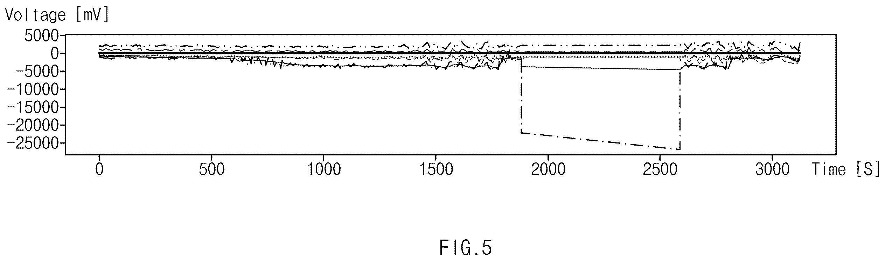

FIG. 5 is a graph showing a long moving average and a short moving average of a first voltage of a battery cell,

according to an embodiment disclosed herein.

Referring to FIG. 5, the controller 220 may calculate the long moving average of each of the plurality of battery cells 110, 120, 130, and 140 by using first voltage dV1 data obtained during the recent 100 seconds from calculation based on the first voltage dV1 data of each of the plurality of battery cells 110, 120, 130, and 140, and calculate the short moving average of each of the plurality of battery cells 110, 120, 130, and 140 by using the first voltage dV1 data obtained for the recent 10 seconds from the calculation.

The controller 220 may analyze a long voltage change trend and a short voltage change trend of the first voltage dV1 of each of the plurality of battery cells 110, 120, 130, and 140 by using continuous long moving average dV1_LMA and short moving average dV1_SMA of the first voltage dV1 of each of the plurality of battery cells 110, 120, 130, and 140. The controller 220 may diagnose whether a voltage of each of the plurality of battery cells is abnormal, by using the voltage deviation dV1 with respect to the average voltage V_avg or the long moving average dV1_LMA and the short moving average dV1_SMA of each of the plurality of battery cells 110, 120, 130, and 140.

Referring back to FIG. 4, in operation S103, the controller 220 may calculate ripple noise based on the short moving average dV1_SMA of each of the plurality of battery cells 110, 120, 130, and 140. Herein, the ripple noise may be an alternating current component remaining in direct current, i.e., noise of a voltage, when alternating current is rectified in a rectifying circuit.

In operation S103, the controller 220 may calculate a mean value, a median value, or a minimum value of the short moving average dV1_SMA of each of the plurality of battery cells 110, 120, 130, and 140 as an average short moving average dV1_SMA_avg of the plurality of battery cells 110, 120, 130, and 140.

In operation S103, the controller 220 may calculate a deviation between the average short moving average dV1_SMA_avg and the short moving average dV1_SMA of each of the plurality of battery cells 110, 120, 130, and 140. According to an embodiment, the controller 220 may calculate, as a second voltage dV2, the deviation between the average short moving average dV1_SMA_avg and the short moving average dV1_ SMA of each of the plurality of battery cells 110, 120, 130, and 140.

In operation S103, the controller 220 may calculate time-series data of a long moving average dV2_LMA of each of the plurality of battery cells 110, 120, 130, and 140 by measuring the second voltages dV2 of the plurality of battery cells 110, 120, 130, and 140 in charging, an idle period after charging, discharging, and an idle period after discharging. For example, the controller 220 may calculate the long moving average dV2_LMA of the second voltage dV2 of each of the plurality of battery cells 110, 120, 130, and 140 by applying any one of a simple moving average, a weighted moving average, or an EMA to the entire second voltage dV2 data of each of the plurality of battery cells 110, 120, 130, and 140.

In operation S103, according to an embodiment, the controller 220 may calculate the EMA of the second voltage dV2 of each of the plurality of battery cells 110, 120, 130, and 140 by applying the EMA to the entire second voltage dV2 data of each of the plurality of battery cells 110, 120, 130, and 140. In operation S103, according to an embodiment, the controller 220 may calculate a long moving average having a long window length by using the entire second voltage dV2 data of each of the plurality of battery cells 110, 120, 130, and 140. For example, the window size of the long moving average may include 100 seconds. In operation S103, the controller 220 may calculate, as ripple noise of each of the plurality of battery cells 110, 120, 130, and 140, the long moving average dV2_LMA of the second voltage dV2 of each of the plurality of battery cells 110, 120, 130, and 140.

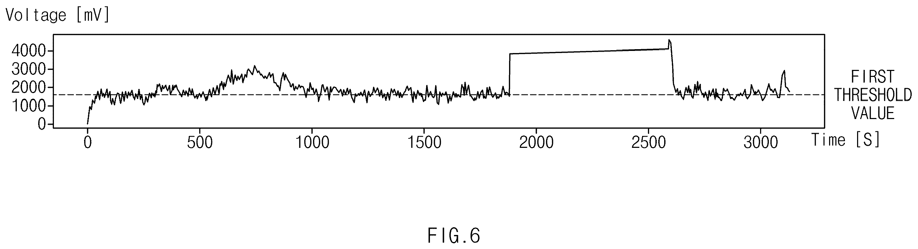

FIG. 6 is a graph showing ripple noise of a battery cell according to an embodiment disclosed herein.

Referring to FIG. 6, the controller 220 may calculate, as the ripple noise of each of the plurality of battery cells 110, 120, 130, and 140, the long moving average dV2_LMA of the second voltage dV2 having a long window size, by using the second voltage dV2 data of each of the plurality of battery cells 110, 120, 130, and 140. For example, the window size of the long moving average may include 100 seconds.

The controller 220 may set a first threshold value by multiplying the average dV2_LAM_avg of ripple noise dV2_LMA of each of the plurality of battery cells 110, 120, 130, and 140 by a first threshold constant C1. Herein, the first threshold constant C1 may include '1.5'. For example, the controller 220 may set, to a first threshold value, a value obtained by multiplying the average dV2_LAM_avg of the ripple noise dV2_LMA of each of the plurality of battery cells 110, 120, 130, and 140 by the first threshold constant C1 of '1.5'. Herein, the threshold value may be defined as a criterion for determining 'abnormality' because an extreme result is output. That is, the threshold value may be defined as a criterion indicating a degree to which data contradicts a particular statistical model.

Referring back to FIG. 4, in operation S104, the controller 220 may determine whether the ripple noise dV2_LMA of each of the plurality of battery cells 110, 120, 130, and 140 exceeds the first threshold value.

In operation S105, the controller 220 may identify, as a target battery cell, a battery cell having the ripple noise dV2_LMA less than or equal to the first threshold value among the plurality of battery cells 110, 120, 130, and 140.

In operation S106, the controller 220 may identify, as a noise battery cell, a battery cell having the ripple noise dV2_LMA exceeding the first threshold value among the plurality of battery cells 110, 120, 130, and 140.

In operation S106, the controller 220 may identify, as target battery cells, the other battery cells than a noise battery cell by removing data of the noise battery cell among the plurality of battery cells 110, 120, 130, and 140.

In operation S107, the controller 220 may diagnose the target battery cell based on a deviation between the long moving average dV1_LMA and the short moving average dV1_SMA of the first voltage of each of the plurality of target battery cells.

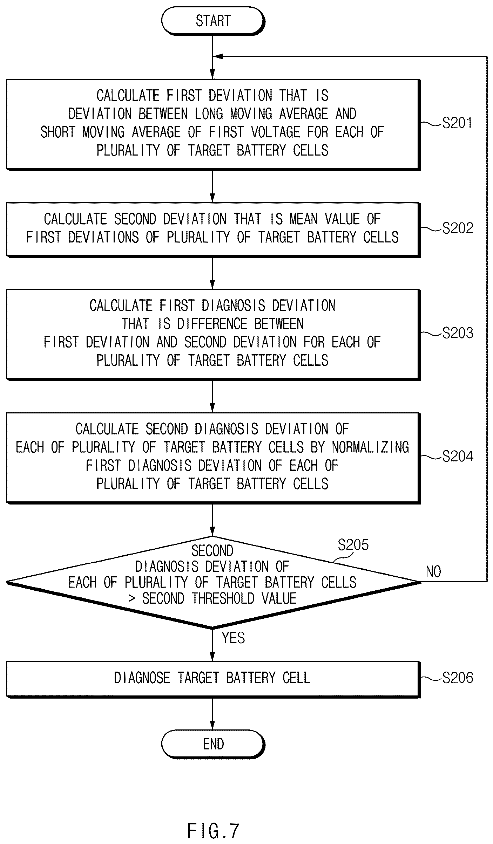

FIG. 7 is a flowchart illustrating a method of diagnosing a target battery cell by a controller, according to an embodiment disclosed herein.

Hereinbelow, a method of diagnosing a target battery cell by the controller will be described in detail with reference to FIG. 7.

In operation S201, the controller 220 may calculate, as a first deviation (dV1_LMA - dV1_SMA) of each of a plurality of target battery cells, a deviation between the long moving average dV1_LMA and the short moving average dV1_SMA of the first voltage dV1 of each of the plurality of target battery cells. In operation S201, that is, the controller 220 may continuously calculate the voltage deviation dV1 with respect to the average voltage V_avg of each of the plurality of target battery cells or a deviation between a long behavior and a short behavior of the voltage.

In operation S201, the controller 220 may calculate time-series data of the first deviation dV1_LMA - dV1_SMA that is a deviation between the long moving average dV1_LMA and the short moving average dV1_SMA of the first voltage dV1 of each of the plurality of target battery cells, by measuring the voltages of the plurality of battery cells 110, 120, 130, and 140 in charging, an idle period after charging, discharging, and an idle period after discharging.

In operation S201, the controller 220 may continuously calculate the first deviation dV1_LMA - dV1_SMA of each of the plurality of target battery cells calculated during a unit time.

In operation S202, the controller 220 may calculate a second deviation (dV1_LMA - dV1_SMA)_AVG that is an average of the first deviation (dV1_LMA - dV1_SMA) of the plurality of target battery cells. In operation S202, the controller 220 may calculate a second deviation (dV1_LMA - dV1_SMA)_AVG that is an average of the first deviations (dV1_LMA - dV1_SMA) of the plurality of target battery cells.

In operation S202, the controller 220 may continuously calculate the first deviation (dV1_LMA - dV1_SMA) of each of the plurality of target battery cells every unit time, and calculate the second deviation (dV1_LMA - dV1_SMA)_AVG that is a mean value, a median value, or a minimum value of the first deviations (dV1_LMA - dV1_SMA) of the plurality of target battery cells by using the first deviations (dV1_LMA - dV1_SMA) of the plurality of target battery cells.

In operation S202, the controller 220 may continuously calculate the second deviations (dV1_LMA - dV1_SMA) _AVG of the plurality of target battery cells calculated every unit time. That is, the controller 220 may calculate a mean value of the deviations of the long behavior and the short behavior of the voltage deviations of the plurality of target battery cells.

In operation S203, the controller 220 may calculate a first diagnosis deviation D1 of each of the plurality of target battery cells, which is a difference between the first deviation (dV1_LMA - dV1_SMA) and the second deviation (dV1_LMA - dV1_SMA)_AVG of each of the plurality of target battery cells.

In operation S203, specifically, the controller 220 may calculate the first diagnosis deviation D1 of each of the plurality of target battery cells, based on Equation 1.

$$\text{First Diagnosis Deviation (D1)} = \text{Second Deviation} - \text{First Deviation} = \text{(dV1\_LMA - dV1\_SMA)}\_AVG - \text{(dV1\_LMA - dV1\_SMA)} \quad \text{[Equation 1]}$$

Referring to Equation 1, the controller 220 may calculate, as the first diagnosis deviation D1 of each of the plurality of target battery cells, a difference between the plurality of first deviations (dV1_LMA - dV1_SMA) and the second deviations (dV1_LMA - dV1_SMA)_AVG.

The controller 220 may calculate time-series data of the first diagnosis deviation D1 of that is a difference between the first deviation (dV1_LMA - dV1_SMA) and the second deviation (dV1_LMA - dV1_SMA)_AVG of each of the plurality of target battery cells, by measuring the voltages of the plurality of target battery cells in charging, an idle period after charging, discharging, and an idle period after discharging.

The controller 220 may continuously calculate the first diagnosis deviation D1 of each of the plurality of target battery cells for each unit time to generate a graph indicating a change in the first diagnosis deviation D1 of each of the plurality of target battery cells.

That is, the controller 220 may calculate the first diagnosis deviation D1 of each of the plurality of target battery cells to compare average long behavior and short behavior deviation of the plurality of battery cells 110, 120, 130, and 140 with a deviation of the long behavior and the short behavior of the first voltage dV1 of each of the plurality of target battery cells.

In operation S204, the controller 220 may calculate the second diagnosis deviation D2 by normalizing the first diagnosis deviation D1 of each of the plurality of target battery cells.

In operation S204, specifically, the controller 220 may calculate the second diagnosis deviation D2 of each of the plurality of target battery cells by normalizing the first diagnosis deviation D1 of each of the plurality of target battery cells, based on Equation 2 below.

Second Diagnosis Deviation = First Diagnosis Deviation / Max[|(dV1_LMA - dV1_SMA)_AVG| * C2, C3]     [Equation 2]

In operation S204, the controller 220 may calculate a maximum value Max between a value |(dV1_LMA-dV1_SMA )_AVG |*C2 obtained by multiplying the absolute value |(dV1_LMA- dV1_SMA )_AVG| of the second deviation by the second threshold constant C2 and the third threshold constant C3. The controller 220 may normalize the first diagnosis deviation D1 of each of the plurality of target battery cells by using the maximum value Max[|(dV_LMA-dV_SMA )_AVG|*C2,C3] between the value obtained by multiplying the absolute value of the second deviation by the third threshold constant and the third threshold constant C3. Herein, the second threshold constant C2 may include '0.1', and the third threshold constant C3 may include '0.1', and the second threshold constant C2 and the third threshold constant C3 may change according to a size and characteristics of the first voltage dV1 data of each of the plurality of target battery cells. In operation S204, the controller 220 may calculate the second diagnosis deviation D2 by normalizing the first diagnosis deviation D1 of each of the plurality of target battery cells using the second deviation (dV1_LMA- dV1_SMA)_AVG indicating a behavior of the average voltage V_avg of the plurality of battery cells 110, 120, 130, and 140.

In operation S204, according to an embodiment, the controller 220 may normalize the first diagnosis deviation D1 of each of the plurality of target battery cells through a log operation. That is, the controller 220 may calculate, as the second diagnosis deviation D2 of each of the plurality of target battery cells, a value obtained by normalizing the first diagnosis deviation D1 of each of the plurality of target battery cells through a log operation.

In operation S204, according to an embodiment, the controller 220 may set, as a normalization reference value, an average D2_avg of the first diagnosis deviation D1 of each of the plurality of target battery cells. In operation S204, the controller 220 may perform normalization by dividing the first diagnosis deviation D1 of each of the plurality of target battery cells by the average value D2_avg of the first diagnosis deviation D1, by using the average D2_avg of the second diagnosis deviation as a normalization reference value. That is, the controller 220 may calculate, as the second diagnosis deviation D2 of each of the plurality of target battery cells, a value obtained by dividing the first diagnosis deviation D1 of each of the plurality of target battery cells by the average D2_avg of the second diagnosis deviation and normalizing the division result.

In operation S204, the controller 220 may calculate the second diagnosis deviation D2 of each of the plurality of target battery cells by normalizing the first diagnosis deviation D1 of each of the plurality of target battery cells, according to various embodiments.

In operation S204, the controller 220 may continuously calculate the second diagnosis deviation D2 of each of the plurality of target battery cells for each unit time to generate a graph indicating a change in the second diagnosis deviation D2 of each of the plurality of target battery cells.

In operation S205, the controller 220 may determine whether the second diagnosis deviation D2 of each of the plurality of target battery cells exceeds a second threshold value. Herein, the second threshold value may be a criterion for determining a target battery cell as a normal battery cell or an abnormal battery cell having an abnormal behavior of a voltage occurring therein. In operation S205, the controller 220 may diagnose at least one of the plurality of target battery cells, based on whether the second diagnosis deviation D2 of each of the plurality of target battery cells exceeds the threshold value.

In operation S206, the controller 220 may diagnose the target battery cell as an abnormal battery cell when the target battery cell has the second diagnosis deviation D2 exceeding the second threshold value among the plurality of target battery cells.

In operation S206, according to an embodiment, when the second diagnosis deviation D2 of at least one of the plurality of target battery cells exceeds the second threshold value, the controller 220 may increase a diagnosis count value of the at least one target battery cell. In operation S206, according to an embodiment, when the diagnosis count value of at least one of the plurality of target battery cells is greater than or equal to a threshold count, the controller 220 may diagnose the at least one target battery cell.

In operation S206, after diagnosing the at least one of the plurality of battery cells 110, 120, 130, and 140, the controller 220 may track and monitor whether a defect of the battery cell, such as internal short-circuit, external short-circuit, lithium precipitation, etc., occurs. When the controller 220 determines that a defect occurs in the battery cell, as a result of diagnosis, the controller 220 may provide information about the battery cell to a user. For example, the controller 220 may provide information about the battery cell having internal short-circuit occurring to a user terminal through a communication unit (not shown) and provide the information about the battery cell through a display provided in a vehicle, a charger, etc.

As described above, the battery management apparatus 200 according to another embodiment disclosed herein may accurately diagnose an abnormal battery cell by removing noise of a long moving average and a short moving average of a voltage deviation that is a difference between a voltage and an average voltage of battery cells.

In a conventional battery management apparatus, an abnormal behavior signal of a voltage of each battery cell is distorted using a deviation of a voltage of each battery cell with respect to an average voltage of battery cells and there is a possibility of misdiagnosis due to noise data, but the battery management apparatus 200 according to an embodiment disclosed herein may minimize distortion of the voltage of the battery cell by using the deviation of the long moving average value and the short moving average of the voltage deviation of each battery cell, remove noise data, and amplifying the voltage behavior of the abnormal battery cell by applying the skewness of the voltage of the battery cell, thereby improving the accuracy of diagnosis.

The battery management apparatus 200 may early diagnose the battery cell having the abnormal voltage behavior occurring by using the deviation of the long moving average and the short moving average of the voltage deviation of the battery cell, thereby securing safety and reliability of the battery energy. In addition, the battery management apparatus 200 may diagnose quickly and conveniently the battery cell because of no need to remove the battery cell having the abnormal voltage behavior occurring in the state of the battery being mounted on a vehicle.

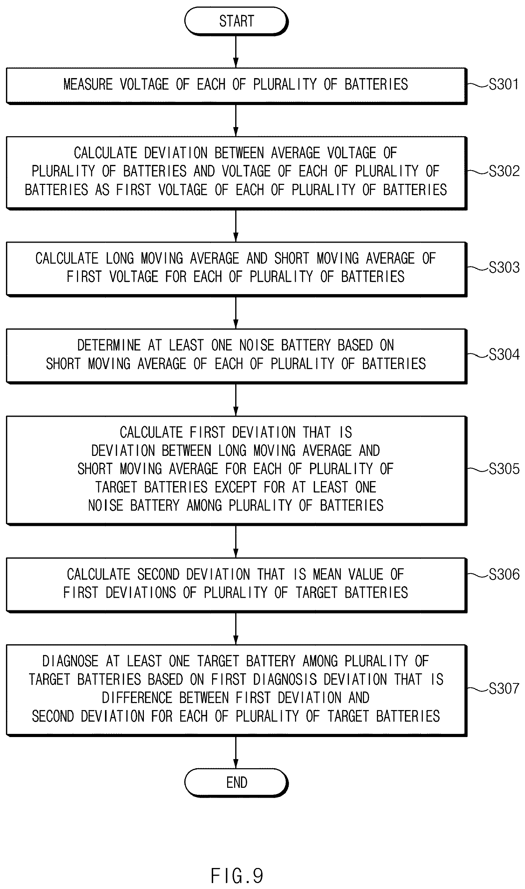

FIG. 9 is a flowchart of an operating method of a battery management apparatus according to an embodiment disclosed herein.

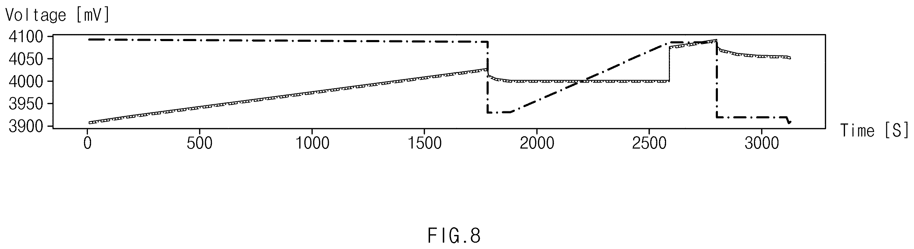

Hereinbelow, an operating method of the battery management apparatus 200 will be described with reference to FIGS. 1 and 8.

The battery management apparatus 200 may be substantially the same as the battery management apparatus 200 described with reference to FIGS. 1 to 8, and thus will be briefly described to avoid redundant description.

Referring to FIG. 9, an operating method of a battery management apparatus may include operation S301 of measuring a voltage of each of a plurality of batteries, operation S302 of calculating a deviation between an average voltage of the plurality of batteries and a voltage of each of the plurality of batteries as a first voltage of each of the plurality of batteries, operation S303 of calculating a long moving average and a short moving average of the first voltage for each of the plurality of batteries, operation S304 of determining at least one noise battery based on the short moving average of the plurality of batteries, operation S305 of calculating a first deviation that is a deviation between the long moving average and the short moving average for each of a plurality of target batteries except for the at least one noise battery among the plurality of batteries, operation S306 of calculating a second deviation which is a mean value of the first deviations of the plurality of target batteries, and operation S307 of diagnosing at least one target battery among the plurality of target batteries, based on a first diagnosis deviation that is a difference between the first deviation and the second deviation for each of the plurality of target batteries.

In operation S301, the voltage measurement unit 210 may calculate the voltage of each of the plurality of battery cells 110, 120, 130, and 140. The voltage measurement unit 210 may calculate the voltage of each of the plurality of battery cells 110, 120, 130, and 140 for each unit time to calculate time-series data of the voltage of each of the plurality of battery cells 110, 120, 130, and 140. In operation S301, according to an embodiment, the voltage measurement unit 210 may continuously calculate voltage rise and drop and long-term relaxation data of the plurality of battery cells 110, 120, 130, and 140 in charging, an idle period after charging, discharging, and an idle period after discharging.

In operation S301, the voltage measurement unit 210 may calculate the time-series data of the voltage of each of the plurality of battery cells 110, 120, 130, and 140 by measuring the voltages of the plurality of battery cells 110, 120, 130, and 140 in charging, an idle period after charging, discharging, and an idle period after discharging. The voltage measurement unit 210 may generate a graph indicating a voltage change of each of the plurality of battery cells 110, 120, 130, and 140 by measuring the voltage of each of the plurality of battery cells 110, 120, 130, and 140 for each unit time.

In operation S302, the controller 220 may calculate an average voltage V_avg of the plurality of battery cells 110, 120, 130, and 140. According to an embodiment, the controller 220 may calculate a mean value Mean, a median value Median, or a minimum value Min of the voltages of the plurality of battery cells 110, 120, 130, and 140 as the average voltage V_avg of the plurality of battery cells 110, 120, 130, and 140. In operation S302, the controller 220 may calculate a deviation dV between the average voltage V_avg and the voltage of each of the plurality of battery cells 110, 120, 130, and 140.

In operation S302, according to an embodiment, the controller 220 may calculate, as a first voltage dV1, the deviation dV between the average voltage V_avg and the voltage of each of the plurality of battery cells 110, 120, 130, and 140. According to an embodiment, the controller 220 may calculate the voltage of each of the plurality of battery cells 110, 120, 130, and 140 as the first voltage dV1 of each of the plurality of battery cells 110, 120, 130, and 140. Hereinbelow, a description will be made using the deviation dV between the voltage of each of the plurality of battery cells 110, 120, 130, and 140 and the average voltage V_avg as the first voltage of each of the plurality of battery cells 110, 120, 130, and 140, but the present disclosure is not limited thereto.

In operation S303, the controller 220 may calculate a moving average of the first voltage dV1 of each of the plurality of battery cells 110, 120, 130, and 140. Herein, the moving average may be an average of some data extracted during movement on a window of a certain size among the entire data. Herein, the window may be a reference period for determining some of the entire data extracted for use. A start point of the window may be a point preceding the present point by a reference time, an end point of the window may be the present point. For example, when the window corresponds to one week, the controller 220 may extract data obtained during the recent one week from the present point from among the entire data.

In operation S303, the controller 220 may calculate the moving average of the first voltage dV1 of each of the plurality of battery cells 110, 120, 130, and 140 by using the first voltage dV1 extracted during movement in a window from time-series data of the entire first voltage dV1 of each of the plurality of battery cells 110, 120, 130, and 140. In operation S303, the controller 220 may calculate a continuous moving average of the first voltage dV1 of each of the plurality of battery cells 110, 120, 130, and 140 by using the first voltage dV1 continuously extracted during movement in the window from the entire first voltage dV1 of each of the plurality of battery cells 110, 120, 130, and 140.

In operation S303, the controller 220 may calculate the time-series data of a long moving average dV1_LMA and a short moving average dV1_SMA of each of the plurality of battery cells 110, 120, 130, and 140 by measuring the voltages of the plurality of battery cells 110, 120, 130, and 140 in charging, an idle period after charging, discharging, and an idle period after discharging. For example, the controller 220 may calculate a voltage deviation dV with respect to the average voltage V_avg or the moving average of the voltage of each of the plurality of battery cells 110, 120, 130, and 140, by applying any one of a simple moving average, a weighted moving average, or an exponential moving average (EMA) to the entire first voltage dV1 data of each of the plurality of battery cells 110, 120, 130, and 140.

In operation S303, according to an embodiment, the controller 220 may calculate the EMA of the first voltage dV1 of each of the plurality of battery cells 110, 120, 130, and 140 by applying the EMA to the entire first voltage dV1 data of each of the plurality of battery cells 110, 120, 130, and 140. The EMA refers to a sort of weighted moving averaging in which a higher weight value is applied to the recent data, while using data of all the past periods.

In operation S303, the controller 220 may calculate a plurality of moving averages having different window sizes by using the entire first voltage dV1 data of each of the plurality of battery cells 110, 120, 130, and 140. According to an embodiment, the controller 220 may calculate a long moving average having a long window length and a short moving average having a short window length by using the entire first voltage dV1 data of each of the plurality of battery cells 110, 120, 130, and 140. For example, the window size of the long moving average may include 100 seconds, and the window size of the short moving average may include 10 seconds.

In operation S303, the controller 220 may determine at least one noise battery cell among the plurality of battery cells 110, 120, 130, and 140, based on the first voltage dV1 of each of the plurality of battery cells 110, 120, 130, and 140. In operation S304, after determining the at least one noise battery cell based on the first voltage dV1 of each of the plurality of battery cells 110, 120, 130, and 140, the controller 220 may identify a plurality of target battery cells except for the at least one noise battery cell from among the plurality of battery cells 110, 120, 130, and 140.

In operation S303, the controller 220 may calculate the long moving average of each of the plurality of battery cells 110, 120, 130, and 140 by using first voltage dV1 data obtained during the recent 100 seconds from calculation using the first voltage dV1 data of each of the plurality of battery cells 110, 120, 130, and 140, and calculate the short moving average of each of the plurality of battery cells 110, 120, 130, and 140 by using the first voltage dV1 data obtained for the recent 10 seconds from the calculation.

In operation S303, the controller 220 may analyze a long voltage change trend and a short voltage change trend of the first voltage dV1 of each of the plurality of battery cells 110, 120, 130, and 140 by using continuous long moving average dV1_LMA and short moving average dV1_SMA of the first voltage dV1 of each of the plurality of battery cells 110, 120, 130, and 140. The controller 220 may diagnose whether a voltage of each of the plurality of battery cells is abnormal, by using the voltage deviation dV1 with respect to the average voltage V_avg or the long moving average dV1_LMA and the short moving average dV1_SMA of each of the plurality of battery cells 110, 120, 130, and 140.

In operation S304, the controller 220 may calculate ripple noise based on the short moving average dV1_SMA of each of the plurality of battery cells 110, 120, 130, and 140.

In operation S304, the controller 220 may calculate a mean value, a median value, or a minimum value of the short moving average dV1_SMA of each of the plurality of battery cells 110, 120, 130, and 140 as an average short moving average dV1_SMA_avg of the plurality of battery cells 110, 120, 130, and 140.

In operation S304, the controller 220 may calculate a deviation between the average short moving average dV1_SMA_avg and the short moving average dV1_SMA of each of the plurality of battery cells 110, 120, 130, and 140. According to an embodiment, the controller 220 may calculate, as a second voltage dV2, the deviation between the average short moving average dV1_SMA_avg and the short moving average dV1_SMA of each of the plurality of battery cells 110, 120, 130, and 140.

In operation S304, the controller 220 may calculate, as the ripple noise of each of the plurality of battery cells 110, 120, 130, and 140, the long moving average dV2_LMA of the second voltage dV2 having a long window size, by using the second voltage dV2 data of each of the plurality of battery cells 110, 120, 130, and 140. For example, the window size of the long moving average may include 100 seconds.

In operation S304, the controller 220 may calculate time-series data of a long moving average dV2_LMA of each of the plurality of battery cells 110, 120, 130, and 140 by measuring the second voltages dV2 of the plurality of battery cells 110, 120, 130, and 140 in charging, an idle period after charging, discharging, and an idle period after discharging. For example, the controller 220 may calculate the long moving average dV2_LMA of the second voltage dV2 of each of the plurality of battery cells 110, 120, 130, and 140 by applying any one of a simple moving average, a weighted moving average, or an EMA to the entire second voltage dV2 data of each of the plurality of battery cells 110, 120, 130, and 140.

In operation S304, according to an embodiment, the controller 220 may calculate the EMA of the second voltage dV2 of each of the plurality of battery cells 110, 120, 130, and 140 by applying the EMA to the entire second voltage dV2 data of each of the plurality of battery cells 110, 120, 130, and 140. In operation S304, according to an embodiment, the controller 220 may calculate a long moving average having a long window length by using the entire second voltage dV2 data of each of the plurality of battery cells 110, 120, 130, and 140. For example, the window size of the long moving average may include 100 seconds. In operation S304, the controller 220 may calculate, as ripple noise of each of the plurality of battery cells 110, 120, 130, and 140, the long moving average dV2_LMA of the second voltage dV2 of each of the plurality of battery cells 110, 120, 130, and 140.

In operation S304, the controller 220 may set a first threshold value by multiplying the average dV2_LAM_avg of ripple noise dV2_LMA of each of the plurality of battery cells 110, 120, 130, and 140 by a first threshold constant C1. Herein, the first threshold constant C1 may include '1.5'. For example, the controller 220 may set, to a first threshold value, a value obtained by multiplying the average dV2_LAM_avg of the ripple noise dV2_LMA of each of the plurality of battery cells 110, 120, 130, and 140 by the first threshold constant C1 of '1.5'. Herein, the threshold value may be defined as a criterion for determining 'abnormality' because an extreme result is output. That is, the threshold value may be defined as a criterion indicating a degree to which data contradicts a particular statistical model.

In operation S304, the controller 220 may determine whether the ripple noise dV2_LMA of each of the plurality of battery cells 110, 120, 130, and 140 exceeds the first threshold value.

In operation S304, the controller 220 may identify, as a target battery cell, a battery cell having the ripple noise dV2_LMA less than or equal to the first threshold value among the plurality of battery cells 110, 120, 130, and 140. In operation S304, the controller 220 may identify, as a noise battery cell, a battery cell having the ripple noise dV2_LMA exceeding the first threshold value among the plurality of battery cells 110, 120, 130, and 140.

In operation S304, the controller 220 may identify, as target battery cells, the other battery cells than a noise battery cell by removing data of the noise battery cell among the plurality of battery cells 110, 120, 130, and 140. The controller 220 may diagnose the target battery cell based on a deviation between the long moving average dV1_LMA and the short moving average dV1_SMA of the first voltage of each of the plurality of target battery cells.

In operation S305, the controller 220 may calculate, as a first deviation (dV1_LMA- dV1_SMA) of each of a plurality of target battery cells, a deviation between the long moving average dV1_LMA and the short moving average dV1_SMA of the first voltage dV1 of each of the plurality of target battery cells. In operation S201, that is, the controller 220 may continuously calculate the voltage deviation dV1 with respect to the average voltage V_avg of each of the plurality of target battery cells or a deviation between a long behavior and a short behavior of the voltage.

In operation S305, the controller 220 may calculate time-series data of the first deviation dV1_LMA - dV1_SMA that is a deviation between the long moving average dV1_LMA and the short moving average dV1_SMA of the first voltage dV1 of each of the plurality of target battery cells, by measuring the voltages of the plurality of battery cells 110, 120, 130, and 140 in charging, an idle period after charging, discharging, and an idle period after discharging. In operation S305, the controller 220 may continuously calculate the first deviation dV1_LMA - dV1_SMA of each of the plurality of target battery cells calculated during a unit time.

In operation S306, the controller 220 may calculate a second deviation (dV1_LMA - dV1_SMA)_AVG that is an average of the first deviation (dV1_LMA - dV1_SMA) of the plurality of target battery cells. In operation S202, the controller 220 may calculate a second deviation (dV1_LMA - dV1_SMA)_AVG that is an average of the first deviations (dV1_LMA - dV1_SMA) of the plurality of target battery cells.

In operation S306, the controller 220 may continuously calculate the first deviation (dV1_LMA - dV1_SMA) of each of the plurality of target battery cells every unit time, and calculate the second deviation (dV1_LMA - dV1_SMA)_AVG that is a mean value, a median value, or a minimum value of the first deviations (dV1_LMA - dV1_SMA) of the plurality of target battery cells by using the first deviations (dV1_LMA - dVl_SMA) of the plurality of target battery cells. In operation S306, the controller 220 may continuously calculate the second deviations (dV1_LMA - dV1_SMA)_AVG of the plurality of target battery cells calculated every unit time. That is, the controller 220 may calculate a mean value of the deviations of the long behavior and the short behavior of the voltage deviations of the plurality of target battery cells.

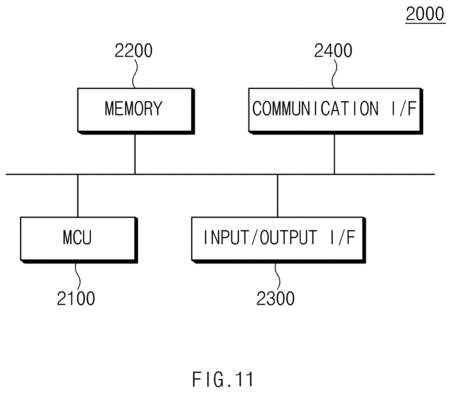

FIG. 11 is a flowchart illustrating an operating method of diagnosing a target battery cell by a battery management apparatus, according to an embodiment disclosed herein.

Hereinbelow, a method, performed by the battery management apparatus 200, of diagnosing a target battery cell will be described in detail with reference to FIG. 11.

In operation S401, the controller 220 may calculate a first diagnosis deviation D1 of each of the plurality of target battery cells, which is a difference between the first deviation (dV1_LMA - dV1_SMA) and the second deviation (dV1_LMA - dV1_SMA)_AVG of each of the plurality of target battery cells.

In operation S401, specifically, the controller 220 may calculate the first diagnosis deviation D1 of each of the plurality of target battery cells, based on Equation 3.

First Diagnosis Deviation (D1) = Second Deviation - First Deviation = (dV1_LMA - dV1_SMA) _AVG-(dV1_LMA - dV1_SMA)    [Equation 3]

Referring to Equation 3, the controller 220 may calculate, as the first diagnosis deviation D1 of each of the plurality of target battery cells, a difference between the plurality of first deviations (dV1_LMA - dV1_SMA) and the second deviations (dV1_LMA - dV1_SMA)_AVG.

In operation S401, the controller 220 may calculate time-series data of the first diagnosis deviation D1 of that is a difference between the first deviation (dV1_LMA - dV1_SMA) and the second deviation (dV1_LMA - dV1_SMA)_AVG of each of the plurality of target battery cells, by measuring the voltages of the plurality of target battery cells in charging, an idle period after charging, discharging, and an idle period after discharging. The controller 220 may continuously calculate the first diagnosis deviation D1 of each of the plurality of target battery cells for each unit time to generate a graph indicating a change in the first diagnosis deviation D1 of each of the plurality of target battery cells.

In operation S401, the controller 220 may calculate the first diagnosis deviation D1 of each of the plurality of target battery cells to compare a deviation between average long behavior and short behavior of the plurality of battery cells 110, 120, 130, and 140 with a deviation of the long behavior and the short behavior of the first voltage dV1 of each of the plurality of target battery cells.

In operation S402, the controller 220 may calculate the second diagnosis deviation D2 by normalizing the first diagnosis deviation D1 of each of the plurality of target battery cells.

In operation S402, specifically, the controller 220 may calculate the second diagnosis deviation D2 of each of the plurality of target battery cells by normalizing the first diagnosis deviation D1 of each of the plurality of target battery cells, based on Equation 2 below.

Second Diagnosis Deviation = First Diagnosis Deviation / Max[|(dV1_LMA - dV1_SMA)_AVG| * C2, C3]    [Equation 4]

In operation S402, the controller 220 may calculate a maximum value Max between a value |(dV1_LMA-dV1_SMA )_AVG |*C2 obtained by multiplying the absolute value |(dV1_LMA- dV1_SMA )_AVG| of the second deviation by the second threshold constant C2 and the third threshold constant C3. The controller 220 may normalize the first diagnosis deviation D1 of each of the plurality of target battery cells by using the maximum value Max[|(dV_LMA-dV_SMA )_AVG|*C2,C3] between the value obtained by multiplying the absolute value of the second deviation by the third threshold constant and the third threshold constant C3. Herein, the second threshold constant C2 may include '0.1', and the third threshold constant C3 may include '0.1', and the second threshold constant C2 and the third threshold constant C3 may change according to a size and characteristics of the first voltage dV1 data of each of the plurality of target battery cells. In operation S402, the controller 220 may calculate the second diagnosis deviation D2 by normalizing the first diagnosis deviation D1 of each of the plurality of target battery cells using the second deviation (dV1_LMA- dV1_SMA) _AVG indicating a behavior of the average voltage V_avg of the plurality of battery cells 110, 120, 130, and 140.

In operation S402, according to an embodiment, the controller 220 may normalize the first diagnosis deviation D1 of each of the plurality of target battery cells through a log operation. That is, the controller 220 may calculate, as the second diagnosis deviation D2 of each of the plurality of target battery cells, a value obtained by normalizing the first diagnosis deviation D1 of each of the plurality of target battery cells through a log operation.

In operation S402, according to an embodiment, the controller 220 may set, as a normalization reference value, an average D2_avg of the first diagnosis deviation D1 of each of the plurality of target battery cells. In operation S402, the controller 220 may perform normalization by dividing the first diagnosis deviation D1 of each of the plurality of target battery cells by the average value D2_avg of the first diagnosis deviation D1, by using the average D2_avg of the second diagnosis deviation as a normalization reference value. That is, the controller 220 may calculate, as the second diagnosis deviation D2 of each of the plurality of target battery cells, a value obtained by dividing the first diagnosis deviation D1 of each of the plurality of target battery cells by the average D2_avg of the second diagnosis deviation.

In operation S402, the controller 220 may calculate the second diagnosis deviation D2 of each of the plurality of target battery cells by normalizing the first diagnosis deviation D1 of each of the plurality of target battery cells, according to various embodiments.

In operation S402, the controller 220 may continuously calculate the second diagnosis deviation D2 of each of the plurality of target battery cells for each unit time to generate a graph indicating a change in the second diagnosis deviation D2 of each of the plurality of target battery cells.

In operation S403, the controller 220 may determine whether the second diagnosis deviation D2 of each of the plurality of target battery cells exceeds a second threshold value. Herein, the second threshold value may be a criterion for determining a target battery cell as a normal battery cell or an abnormal battery cell having an abnormal behavior of a voltage occurring therein. In operation S403, the controller 220 may diagnose at least one of the plurality of target battery cells, based on whether the second diagnosis deviation D2 of each of the plurality of target battery cells exceeds the threshold value.

In operation S404, the controller 220 may diagnose the target battery cell as an abnormal battery cell when the target battery cell has the second diagnosis deviation D2 exceeding the second threshold value among the plurality of target battery cells.

In operation S404, according to an embodiment, when the second diagnosis deviation D2 of at least one of the plurality of target battery cells exceeds the second threshold value, the controller 220 may increase a diagnosis count value of the at least one target battery cell. In operation S402, according to an embodiment, when the diagnosis count value of at least one of the plurality of target battery cells is greater than or equal to a threshold count, the controller 220 may diagnose the at least one target battery cell.

In operation S404, after diagnosing the at least one of the plurality of battery cells 110, 120, 130, and 140, the controller 220 may track and monitor whether a defect of the battery cell, such as internal short-circuit, external short-circuit, lithium precipitation, etc., occurs. When the controller 220 determines that a defect occurs in the battery cell, as a result of diagnosis, the controller 220 may provide information about the battery cell to a user. For example, the controller 220 may provide information about the battery cell having internal short-circuit occurring to a user terminal through a communication unit (not shown) and provide the information about the battery cell through a display provided in a vehicle, a charger, etc.

FIG. 11 is a block diagram showing a hardware configuration of a computing system for performing an operating method of a battery management apparatus, according to an embodiment disclosed herein.

Referring to FIG. 11, a computing system 2000 according to an embodiment disclosed herein may include an MCU 2100, a memory 2200, an input/output I/F 2300, and a communication I/F 2400.

The MCU 2100 may be a processor that executes various programs (e.g., a battery voltage deviation analysis program, etc.) stored in the memory 2200, processes various data through these programs, and perform the above-described functions of the battery management apparatus 200 shown in FIG. 1.

The memory 2200 may store various programs regarding operations of the battery management apparatus 200. Moreover, the memory 2200 may store operation data of the battery management apparatus 200.

The memory 2200 may be provided in plural, depending on a need. The memory 2200 may be volatile memory or non-volatile memory. For the memory 2200 as the volatile memory, random access memory (RAM), dynamic RAM (DRAM), static RAM (SRAM), etc., may be used. For the memory 2200 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 2200 are merely examples and are not limited thereto.

The input/output I/F 2300 may provide an interface for transmitting and receiving data by connecting an input device (not shown) such as a keyboard, a mouse, a touch panel, etc., and an output device such as a display (not shown), etc., to the MCU 2100.

The communication I/F 2400, which is a component capable of transmitting and receiving various data to and from a server, may be various devices capable of supporting wired or wireless communication. For example, a program for resistance measurement and abnormality diagnosis of the battery cell or various data may be transmitted and received to and from a separately provided external server through the communication I/F 2400.

The above description is merely illustrative of the technical idea of the present disclosure, and various modifications and variations will be possible without departing from the essential characteristics of the present disclosure by those of ordinary skill in the art to which the present disclosure pertains.

Therefore, the embodiments disclosed in the present disclosure are intended for description rather than limitation of the technical spirit of the present disclosure and the scope of the technical spirit of the present disclosure is not limited by these embodiments. The protection scope of the present disclosure should be interpreted by the following claims, and all technical spirits within the same range should be understood to be included in the range of the present disclosure.

[Description of Symbols]

1000: Battery Pack
100: Battery Module
110: First Battery Cell
120: Second Battery Cell
130: Third Battery Cell
140: Fourth Battery Cell
200: Battery Management Apparatus

210: Voltage Measurement Unit
220: Controller
300: Relay
2000: Computing System
2100: MCU
2200: Memory
2300: Input/Output I/F
2400: Communication I/F

**Claims**

1. A battery management apparatus comprising:

   a voltage measurement unit configured to measure a voltage of each of a plurality of batteries; and
   a controller configured to:

   calculate, as a first voltage of each of the plurality of batteries, a deviation between an average voltage of the plurality of batteries and the voltage of each of the plurality of batteries;
   calculate a long moving average and a short moving average of the first voltage for each of the plurality of batteries;
   determine at least one noise battery based on the short moving average of each of the plurality of batteries;
   calculate a first deviation that is a deviation between the long moving average and the short moving average for each of a plurality of target batteries except for the at least one noise battery among the plurality of batteries; and
   calculate a second deviation that is a mean value of first deviations of the plurality of target batteries and diagnose at least one target battery among the plurality of target batteries based on a first diagnosis deviation that is a difference between the first deviation and the second deviation for each of the plurality of target batteries.

2. The battery management apparatus of claim 1, wherein the controller is further configured to calculate a mean value, a median value, or a minimum value of voltages of the plurality of batteries as the average voltage of the plurality of batteries and calculate a mean value, a median value, or a minimum value of the first deviations of the plurality of target batteries as the second deviation.

3. The battery management apparatus of claim 2, wherein the controller is further configured to:

   calculate a mean value, a median value, or a minimum value of short moving averages of the plurality of batteries as an average short moving average of the plurality of batteries; and
   calculate a deviation between the average short moving average of the plurality of batteries and the short moving average of each of the plurality of batteries as a second voltage of each of the plurality of batteries.

4. The battery management apparatus of claim 3, wherein the controller is further configured to calculate a long moving average of the second voltage of each of the plurality of batteries as ripple noise of each of the plurality of batteries.

5. The battery management apparatus of claim 4, wherein the controller is further configured to:

   set a first threshold value by multiplying an average of the ripple noise of the plurality of batteries by a first threshold constant; and
   determine a battery having the ripple noise not equal to the first threshold value among the plurality of batteries as the at least one noise battery.

6. The battery management apparatus of claim 2, wherein the controller is further configured to perform normalization by dividing the first diagnosis deviation of each of the plurality of target batteries by a maximum value between a value, obtained by multiplying the second deviation by a second threshold constant, and a third threshold constant to calculate a second diagnosis deviation of each of the plurality of target batteries.

7. The battery management apparatus of claim 6, wherein the controller is further configured to diagnose at least one target battery among the plurality of target batteries based on whether the second diagnosis deviation of each of the plurality of target batteries exceeds the second threshold value.

8. An operating method of a battery management apparatus, the operating method comprising:

measuring a voltage of each of a plurality of batteries;
calculating, as a first voltage of each of the plurality of batteries, a deviation between an average voltage of the plurality of batteries and the voltage of each of the plurality of batteries;
calculating a long moving average and a short moving average of the first voltage for each of the plurality of batteries;
determining at least one noise battery based on the short moving average of each of the plurality of batteries;
calculating a first deviation that is a deviation between the long moving average and the short moving average for each of a plurality of target batteries except for the at least one noise battery among the plurality of batteries;
calculating a second deviation that is a mean value of the first deviations of the plurality of target batteries; and
diagnosing at least one target battery among the plurality of target batteries based on a first diagnosis deviation that is a difference between the first deviation and the second deviation for each of the plurality of target batteries.

9. The operating method of claim 8, wherein the calculating, as the first voltage of each of the plurality of batteries, of the deviation between the average voltage of the plurality of batteries and the voltage of each of the plurality of batteries comprises calculating a mean value, a median value, or a minimum value of voltages of the plurality of batteries as the average voltage of the plurality of batteries, and
the calculating of the second deviation that is a mean value of the first deviations of the plurality of target batteries comprises calculating a mean value, a median value, or a minimum value of the first deviations of the plurality of target batteries as the second deviation.

10. The operating method of claim 9, wherein the determining of the at least one noise battery based on the short moving average of each of the plurality of batteries comprises:

calculating a mean value, a median value, or a minimum value of short moving averages of the plurality of batteries as an average short moving average of the plurality of batteries; and
calculating a deviation between the average short moving average of the plurality of batteries and the short moving average of each of the plurality of batteries as a second voltage of each of the plurality of batteries.

11. The operating method of claim 10, wherein the determining of the at least one noise battery based on the short moving average of each of the plurality of batteries comprises calculating a long moving average of the second voltage of each of the plurality of batteries as ripple noise of each of the plurality of batteries.

12. The operating method of claim 11, wherein the determining of the at least one noise battery based on the short moving average of each of the plurality of batteries comprises setting a first threshold value by multiplying an average of the ripple noise of the plurality of batteries by a first threshold constant and determining a battery having the ripple noise not equal to the first threshold value among the plurality of batteries as the at least one noise battery.

13. The operating method of claim 12, wherein the diagnosing of the at least one target battery among the plurality of target batteries based on the first diagnosis deviation that is the difference between the first deviation and the second deviation for each of the plurality of target batteries comprises performing normalization by dividing the first diagnosis deviation of each of the plurality of target batteries by a maximum value between a value, obtained by multiplying the second deviation by a second threshold constant, and a third threshold constant to calculate a second diagnosis deviation of each of the plurality of target batteries.

14. The operating method of claim 13, wherein the diagnosing of the at least one target battery among the plurality of target batteries based on the first diagnosis deviation that is the difference between the first deviation and the second deviation for each of the plurality of target batteries comprises diagnosing at least one target battery among the plurality of target batteries based on whether the second diagnosis deviation of each of the plurality of target batteries exceeds the second threshold value.

1000

300

BATTERY MANAGEMENT
APPARATUS
200

100

110

120

130

140

FIG.1

200

| VOLTAGE MEASUREMENT UNIT 210 | CONTROLLER 220 |
|---|---|

FIG.2

FIG.3

EP 4 726 420 A1

START

CALCULATE DEVIATION BETWEEN AVERAGE VOLTAGE OF
PLURALITY OF BATTERY CELLS AND VOLTAGE OF
EACH OF PLURALITY OF BATTERY CELLS AS
FIRST VOLTAGE OF EACH OF PLURALITY OF BATTERY CELLS ～S101

CALCULATE LONG MOVING AVERAGE AND
SHORT MOVING AVERAGE OF
FIRST VOLTAGE FOR EACH OF PLURALITY OF BATTERY CELLS ～S102

CALCULATE RIPPLE NOISE BASED ON
SHORT MOVING AVERAGE OF
EACH OF PLURALITY OF BATTERY CELLS ～S103

S104
RIPPLE NOISE OF
EACH OF PLURALITY OF BATTERY CELLS >
FIRST THRESHOLD VALUE?

YES

NO

IDENTIFY TARGET BATTERY CELL ～S105

DETERMINE NOISE BATTERY CELL ～S106

DIAGNOSE TARGET BATTERY CELL BASED ON
DEVIATION BETWEEN LONG MOVING AVERAGE AND
SHORT MOVING AVERAGE OF FIRST VOLTAGE OF EACH OF
OF PLURALITY OF TARGET BATTERY CELLS ～S107

END

FIG.4

FIG.5

FIG.6

START

CALCULATE FIRST DEVIATION THAT IS
DEVIATION BETWEEN LONG MOVING AVERAGE AND
SHORT MOVING AVERAGE OF FIRST VOLTAGE FOR EACH OF
PLURALITY OF TARGET BATTERY CELLS ~S201

CALCULATE SECOND DEVIATION THAT IS MEAN VALUE OF
FIRST DEVIATIONS OF PLURALITY OF TARGET BATTERY CELLS ~S202

CALCULATE FIRST DIAGNOSIS DEVIATION
THAT IS DIFFERENCE BETWEEN
FIRST DEVIATION AND SECOND DEVIATION FOR EACH OF
PLURALITY OF TARGET BATTERY CELLS ~S203

CALCULATE SECOND DIAGNOSIS DEVIATION OF
EACH OF PLURALITY OF TARGET BATTERY CELLS BY NORMALIZING
FIRST DIAGNOSIS DEVIATION OF EACH OF
PLURALITY OF TARGET BATTERY CELLS ~S204

SECOND
DIAGNOSIS DEVIATION OF
EACH OF PLURALITY OF TARGET BATTERY CELLS
> SECOND THRESHOLD VALUE          S205          NO

YES

DIAGNOSE TARGET BATTERY CELL ~S206

END

FIG.7

FIG.8

EP 4 726 420 A1

START

MEASURE VOLTAGE OF EACH OF PLURALITY OF BATTERIES — S301

CALCULATE DEVIATION BETWEEN AVERAGE VOLTAGE OF PLURALITY OF BATTERIES AND VOLTAGE OF EACH OF PLURALITY OF BATTERIES AS FIRST VOLTAGE OF EACH OF PLURALITY OF BATTERIES — S302

CALCULATE LONG MOVING AVERAGE AND SHORT MOVING AVERAGE OF FIRST VOLTAGE FOR EACH OF PLURALITY OF BATTERIES — S303

DETERMINE AT LEAST ONE NOISE BATTERY BASED ON SHORT MOVING AVERAGE OF EACH OF PLURALITY OF BATTERIES — S304

CALCULATE FIRST DEVIATION THAT IS DEVIATION BETWEEN LONG MOVING AVERAGE AND SHORT MOVING AVERAGE FOR EACH OF PLURALITY OF TARGET BATTERIES EXCEPT FOR AT LEAST ONE NOISE BATTERY AMONG PLURALITY OF BATTERIES — S305

CALCULATE SECOND DEVIATION THAT IS MEAN VALUE OF FIRST DEVIATIONS OF PLURALITY OF TARGET BATTERIES — S306

DIAGNOSE AT LEAST ONE TARGET BATTERY AMONG PLURALITY OF TARGET BATTERIES BASED ON FIRST DIAGNOSIS DEVIATION THAT IS DIFFERENCE BETWEEN FIRST DEVIATION AND SECOND DEVIATION FOR EACH OF PLURALITY OF TARGET BATTERIES — S307

END

FIG.9

START

CALCULATE, AS FIRST DIAGNOSIS DEVIATION,
DIFFERENCE BETWEEN FIRST DEVIATION AND
SECOND DEVIATION FOR EACH OF PLURALITY OF
TARGET BATTERY CELLS — S401

CALCULATE SECOND DIAGNOSIS
DEVIATION BY NORMALIZING
FIRST DIAGNOSIS DEVIATION OF EACH OF
PLURALITY OF TARGET BATTERY CELLS — S402

SECOND
DIAGNOSIS DEVIATION OF
EACH OF PLURALITY OF TARGET BATTERY CELLS
> SECOND THRESHOLD VALUE? — S403

NO

YES

DIAGNOSE TARGET BATTERY CELL — S404

END

FIG.10

2000

2200                    2400

| MEMORY | | COMMUNICATION I/F |

| MCU | | INPUT/OUTPUT I/F |

2100                    2300

FIG.11

## INTERNATIONAL SEARCH REPORT

| International application No. |
| --- |
| **PCT/KR2024/009774** |

| | |
| --- | --- |
| **A.** | **CLASSIFICATION OF SUBJECT MATTER** |

**G01R 31/396**(2019.01)i; **G01R 31/385**(2019.01)i; **G01R 19/00**(2006.01)i; **G01R 19/165**(2006.01)i; **G01R 31/392**(2019.01)i; **G01R 31/367**(2019.01)i

According to International Patent Classification (IPC) or to both national classification and IPC

| | |
| --- | --- |
| **B.** | **FIELDS SEARCHED** |

Minimum documentation searched (classification system followed by classification symbols)

G01R 31/396(2019.01); B62D 5/04(2006.01); G01R 19/00(2006.01); G01R 31/34(2006.01); G01R 31/36(2006.01); H01M 10/42(2006.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 노이즈 데이터(noise data), 윈도우(window), 이동 평균(moving average), 편차(deviation)

| | |
| --- | --- |
| **C.** | **DOCUMENTS CONSIDERED TO BE RELEVANT** |

| Category* | Citation of document, with indication, where appropriate, of the relevant passages | Relevant to claim No. |
| --- | --- | --- |
| A | KR 10-2022-0074797 A (LG ENERGY SOLUTION, LTD.) 03 June 2022 (2022-06-03)<br>See claims 1 and 4; and figure 1. | 1-14 |
| A | KR 10-2014-0111920 A (SAMSUNG SDI CO., LTD.) 22 September 2014 (2014-09-22)<br>See paragraphs [0036]-[0104]; and figures 1-7. | 1-14 |
| A | KR 10-2019-0050386 A (KOO, Bon Hyeok) 13 May 2019 (2019-05-13)<br>See paragraphs [0031]-[0107]; and figures 1-3. | 1-14 |
| A | JP 2020-119712 A (TOSHIBA CORP. et al.) 06 August 2020 (2020-08-06)<br>See paragraphs [0009]-[0030]; and figures 1-3. | 1-14 |
| A | US 2018-0194391 A1 (CONTINENTAL AUTOMOTIVE FRANCE et al.) 12 July 2018 (2018-07-12)<br>See paragraphs [0054]-[0117]; and figures 1-2. | 1-14 |

☐ Further documents are listed in the continuation of Box C.  ☑ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **18 October 2024** | **18 October 2024** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

| Patent document cited in search report | | | Publication date (day/month/year) | Patent family member(s) | | | Publication date (day/month/year) |
|---|---|---|---|---|---|---|---|
| KR | 10-2022-0074797 | A | 03 June 2022 | CN | 115461634 | A | 09 December 2022 |
| | | | | EP | 4152021 | A1 | 22 March 2023 |
| | | | | EP | 4152021 | A4 | 03 January 2024 |
| | | | | JP | 2023-519949 | A | 15 May 2023 |
| | | | | JP | 2024-099795 | A | 25 July 2024 |
| | | | | JP | 7483922 | B2 | 15 May 2024 |
| | | | | KR | 10-2024-0109971 | A | 12 July 2024 |
| | | | | KR | 10-2684286 | B1 | 11 July 2024 |
| | | | | US | 11768251 | B2 | 26 September 2023 |
| | | | | US | 2023-0152388 | A1 | 18 May 2023 |
| | | | | US | 2023-0243895 | A1 | 03 August 2023 |
| | | | | WO | 2022-114871 | A1 | 02 June 2022 |
| KR | 10-2014-0111920 | A | 22 September 2014 | CN | 104049213 | A | 17 September 2014 |
| | | | | EP | 2778700 | A2 | 17 September 2014 |
| | | | | US | 2014-0278169 | A1 | 18 September 2014 |
| KR | 10-2019-0050386 | A | 13 May 2019 | KR | 10-2014719 | B1 | 27 August 2019 |
| JP | 2020-119712 | A | 06 August 2020 | JP | 7265364 | B2 | 26 April 2023 |
| | | | | US | 11300625 | B2 | 12 April 2022 |
| | | | | US | 2020-0233037 | A1 | 23 July 2020 |
| US | 2018-0194391 | A1 | 12 July 2018 | CN | 107848563 | A | 27 March 2018 |
| | | | | CN | 107848563 | B | 10 July 2020 |
| | | | | FR | 3039283 | A1 | 27 January 2017 |
| | | | | FR | 3039283 | B1 | 27 January 2017 |
| | | | | KR | 10-2018-0030888 | A | 26 March 2018 |
| | | | | KR | 10-2068914 | B1 | 21 January 2020 |
| | | | | US | 10906580 | B2 | 02 February 2021 |
| | | | | WO | 2017-012704 | A1 | 26 January 2017 |

Form PCT/ISA/210 (patent family annex) (July 2022)

**EP 4 726 420 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230090673